# EUROPÄISCHE PATENTSCHRIFT

(11) **EP 3 133 634 B1**
(45) Veröffentlichungstag und Bekanntmachung des Hinweises auf die Patenterteilung: **30.09.2020**
(21) Anmeldenummer: 16183036.9
(22) Anmeldetag: 05.08.2016
(51) Int. Cl.: H01J 37/32, H01J 37/34, H05H 1/48

(54) **VORRICHTUNG ZUM ZÜNDEN EINER VAKUUMBOGENENTLADUNG UND VERFAHREN ZU DEREN ANWENDUNG**
DEVICE FOR IGNITING A VACUUM ARC DISCHARGE AND METHOD FOR USE THEREOF
DISPOSITIF D'AMORÇAGE D'UNE DECHARGE EN ARC SOUS VIDE ET SON PROCEDE D'UTILISATION

(30) Priorität: 09.08.2015 DE 102015113104; 09.08.2015 DE 202015104164 U
(43) Veröffentlichungstag der Anmeldung: 22.02.2017
(73) Patentinhaber: ISA Installations-, Steuerungs- und Automatisierungssystem GmbH, 01257 Dresden (DE); VTD Vakuumtechnik Dresden GmbH, 01257 Dresden (DE)
(72) Erfinder: Fischer, Dietmar, 01259 Dresden (DE); Falz, Michael, 01156 Dresden (DE); Gebhardt, Barbara, 01809 Heidenau (DE); Brücke, Jörg, 01187 Dresden (DE)
(74) Vertreter: Kailuweit & Uhlemann Patentanwälte Partnerschaft mbB

(56) Entgegenhaltungen:
- EP-A2- 0 213 716
- WO-A1-85/03954
- DE-A1- 10 155 120
- DE-C2- 10 042 629
- FR-A5- 2 108 266

## Beschreibung

Die Erfindung betrifft eine Vorrichtung zum Zünden einer Vakuumbogenentladung mit den Merkmalen nach Anspruch 1 und zugehörigem Verfahren zu deren Anwendung mit den Merkmalen nach Anspruch 4. Die Vorrichtungen dienen insbesondere zur leistungsstarken Beschichtung von funktionellen oder dekorativen Beschichtungen aus verdampfbaren Materialien auf Substraten wie beispielhaft Werkzeuge, Reflektoren oder Dekorelemente.

Nach dem Stand der Technik sind verschiedene Lösungen zum Zünden einer niederenergetischen Vakuumbogenentladung, auch Lichtbogenentladung genannt, bekannt. Als Stand der Technik sind hier insbesondere Lösungen relevant, die mittels Hilfsplasmaeinrichtungen geeignete Bedingungen zum Zünden der Vakuumbogenentladung schaffen.

Die DE 10042629 C2 gibt einen Lichtbogenverdampfer mit einer Kathode, einer Anode und einer Zündeinrichtung an. Die Zündeinrichtung umfasst eine lonenquelle, welche Ionen in den Raum zwischen der Kathode und der Anode einbringt. Die lonenquelle ist vorzugsweise selbst eine Hilfsplasmaeinrichtung, mit der Material zur Bereitstellung der freien Ionen verdampft und in einen Plasmazustand überführt wird. Die Hilfsplasmaeinrichtung ist aus einer Zündelektrode und einer Hilfsanode aufgebaut, die durch einen isolierenden Träger getrennt sind, auf dem sich Material zur Lieferung der freien Ionen befindet. Durch Beaufschlagung mit einem Zündimpuls wird ein starker Stromfluss über den Träger ausgelöst und das Material verdampft und in den Plasmazustand überführt. Eine Lade- und Kontrolleinheit zur Messung der Lichtbogenspannung zwischen der Kathode und der Anode betätigt in Abhängigkeit der gemessenen Lichtbogenspannung die Zündvorrichtung. Die Lichtbogenspannung wird laufend gemessen und bei Erreichen eines kritischen Wertes wird die Zündvorrichtung abermals betätigt, bevor der Lichtbogen erlischt.

In der DE 101 55 120 A1 wird ein Verfahren und eine Vorrichtung zur Initiierung einer gepulsten Bogenentladung offenbart. Dazu weist die offenbarte Vorrichtung eine mechanische Zündeinrichtung auf, welche auf einer Kreisbahn angeordnete Elektrodensegmente vorsieht. Ein Stromabnehmer wird hierbei über die Elektrodensegmente geführt wobei der Schaltungszustand periodisch zwischen Zu- und Abschalten des Zündplasmas ändert. Somit wird mechanisch die Ausbildung einer Vakuumbogenentladung initiiert.

Der Erfindung liegt als **Aufgabe** zugrunde, eine Vorrichtung zum Zünden einer Vakuumbogenentladung und Verfahren zu deren Anwendung anzugeben, mit denen eine einfache und sichere Zündung der Vakuumbogenentladung über die gesamte technologisch vorgegebene Betriebszeit gewährleistet ist.

Der Kern der Erfindung besteht darin, dass mit der erfindungsgemäßen Vorrichtung und ihrer verfahrensgemäßen Anwendung in der Nähe des Targets des Vakuumbogenverdampfers an einer Zündelektrode mittels Hilfsplasmaeinrichtungen eine Zündleistung zwischen 30 und 100 kW, vorzugsweise 70 kW, bereitgestellt wird, die geeignet ist, eine Vakuumbogenentladung am Vakuumbogenverdampfer auszulösen. Dazu werden eine Vorrichtung sowie ein entsprechendes Verfahren zur Anwendung der Vorrichtung angegeben.

Bei der Vorrichtung nach Anspruch 1 wird eine Hilfsplasmaeinrichtung angegeben, die eine Zündenergie bereitstellt, welche eine Vakuumbogenentladung am Vakuumbogenverdampfer auslöst. Eine Mess- und Steuereinrichtung erfasst und regelt die elektrischen Parameter. Die Bauelemente der Hilfsplasmaeinrichtung sind so ausgelegt, dass eine angegebene Zündleistung an der Zündelektrode bereitgestellt werden kann.

Zur erstmaligen Zündung eines Vakuumbogens werden in der Vakuumkammer die technologisch vorgegebenen Parameter eingestellt. Das sind insbesondere die erforderliche Art des Prozessgase sowie der Arbeitsdruck. Weiterhin ist der erforderliche Strom für das Target einzustellen. Obwohl danach alle für eine Vakuumbogenverdampfung erforderlichen Betriebsparameter gegeben sind, kommt es nicht zur Zündung eines Vakuumbogens. Dafür ist eine Zündvorrichtung erforderlich. Erfindungsgemäß wird eine Hilfsplasmaeinrichtung angegeben, die über eine Hochspannungsquelle, einen Kondensator sowie eine Zündelektrode in der Nähe des Targets verfügt, wobei verfahrensgemäß an der Zündelektrode eine Zündleistung zwischen 30 und 100 kW, vorzugsweise 70 kW, bereitgestellt wird. Der angegebene relativ große Bereich einer Zündleistung zwischen 30 und 100 kW ergibt sich aus den vielseitigen unterschiedlichen Konfigurationen der einzelnen Vakuumbogenverdampfer in der Praxis. In einzelnen Fällen kann es vorteilhaft sein, den Bereich auch nach oben oder unten auszudehnen.

Nach Anspruch 1 weist die Hilfsplasmaeinrichtung eine Hochspannungsquelle auf, die mit einer Hochspannungselektrode verbunden werden kann. Im Raum zwischen der Hochspannungselektrode und dem Target ist die Zündelektrode vorhanden, die ihrerseits mit einem Kondensator verbunden werden kann, der mit einer Niederspannungsquelle, z.B. der Stromquelle für den Vakuumbogen verbunden ist. Die Erfassung der aktuellen elektrischen Parameter erfolgt ebenfalls über eine Mess- und Steuereinrichtung, die in der Folge die elektrischen Parameter regelt, d.h. insbesondere den Kondensator lädt und zur gegebenen Zeit zur Zündelektrode hin entlädt. Die Hochspannungselektrode kann dabei permanent an der Hochspannungsquelle anliegen oder von der Mess- und Steuereinrichtung nur bei Bedarf zugeschaltet werden.

Der Vorteil der Ausführung nach Anspruch 1 besteht darin, dass für die Hochspannungsquelle geringere Leistungen ermöglicht werden, da der Energieanteil, der über den Kondensator bereitgestellt werden muss, aus einer Niederspannungsquelle gezogen werden kann. Damit können die technischen Aufwendungen für den Hochspannungsteil gesenkt werden.

Gegenüber dem Stand der Technik besteht der Vorteil der Erfindung darin, dass keine mechanisch bewegten Zündvorrichtungen mit ihrem hohen Verschleiß oder Leitpasten und ähnliche Metalldampf bildende Plasmen erforderlich sind.

Die Erfindung realisiert in der Nähe des Targets ein zeitlich und örtlich begrenztes dichtes Plasma mit den gegebenen Prozessgasen, welches eine derartige Dichte aufweist, dass am Target ein Vakuumbogen ausgelöst wird. Außer der Hochspannungsquelle, einem Hochspannung- bzw. (Niederspannung-)Kondensator, einer Zündelektrode und nach Anspruch 1 einer Hochspannungselektrode sind keine weiteren Elemente erforderlich. Die Mess- und Steuereinrichtung ist allgemein bei allen Lösungen auch nach dem Stand der Technik bereits vorhanden.

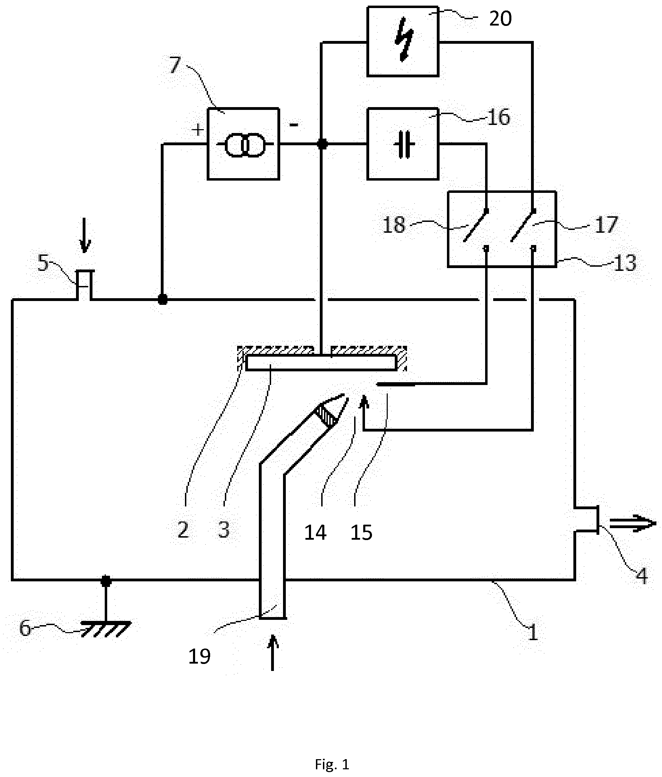

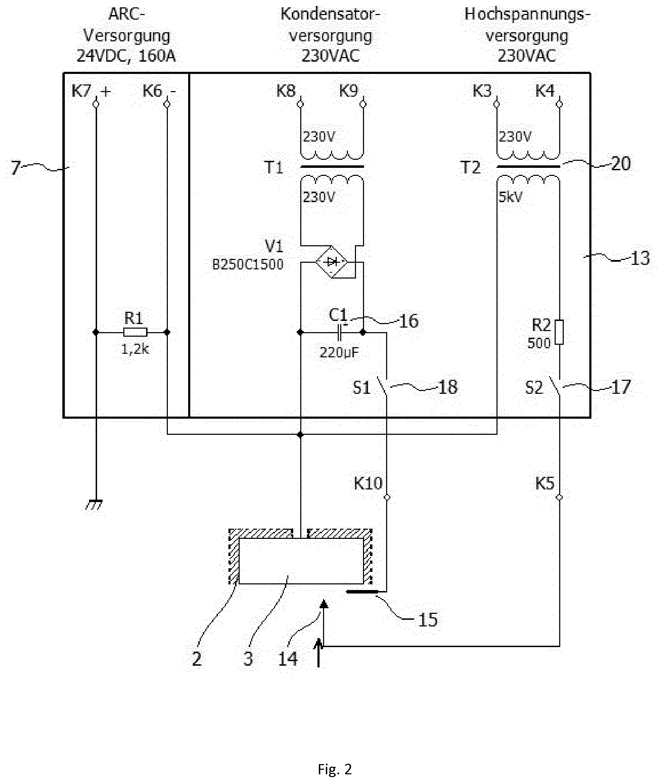

Die Erfindung wird nachstehend an einem Ausführungsbeispiel näher erläutert. Zugehörig zeigt die Figur 1 eine schematische Darstellung einer erfindungsgemäßen Vorrichtung zum Zünden einer Vakuumbogenentladung nach Anspruch 1 und in Figur 2 wird der zugehörige schematische Schaltplan dargestellt.

### Ausführungsbeispiel

Zugehörig zum Ausführungsbeispiel sind die Figuren 1 und 2. In einer Vakuumkammer 1 (Figur 1) befindet sich ein Vakuumbogenverdampfer 2 mit einem Target 3. Die zu beschichtenden Substrate sind zur Vereinfachung der Darstellung nicht dargestellt und befinden sich in der Praxis in der Regel direkt gegenüber dem Target 3. Zur Evakuierung der Vakuumkammer 1 ist ein Vakuumanschluss 4 und zum Einlass eines oder mehrerer Prozessgase ein Gaseinlass 5 vorhanden. Mit einem zusätzlichen Gaseinlass 19, partiell im Bereich der Zündelektroden, kann ein ausreichendes Plasma für die Zündung der Vakuumbogenentladung auch bei Prozessdrücken <10⁻⁴ mbar erzeugt werden. Die Vakuumkammer 1 liegt an Masse 6 und das Target 3 an einer Stromquelle 7.

Nachfolgend wird die erfindungsgemäße Vorrichtung zum Zünden einer Vakuumbogenentladung in der verfahrensgemäßen Anwendung näher beschrieben. Nachdem das Target 3 in dem Vakuumbogenverdampfer positioniert ist sowie die zu beschichtenden Substrate in den Vakuumkammer 1 eingerichtet wurden, werden die technologisch erforderlichen Prozessbedingen hergestellt, indem die Vakuumkammer 1 evakuiert und über den Gaseinlass 5 ein Prozessgas mit einem beispielhaften Druck von 5x10⁻³ mbar eingelassen wird. Bei diesem Prozessdruck ist es für eine sichere Zündung der Vakuumbogenentladung nicht erforderlich, zusätzliches Gas über den Gaseinlass 19 zuzuführen.

Der Betrieb des Vakuumbogenverdampfers 2 wird vorbereitet. Dazu wird über die Stromquelle 7 (Figur 1 und 2) beispielhaft am Target 3 eine Spannung von 24 VDC mit einem Strom von 160 A eingestellt.

Als Hilfsplasmaeinrichtung sind eine Hochspannungsquelle 20 vorhanden, die über eine Mess- und Steuereinrichtung 13 mit einer anodischen Hochspannungselektrode 14 verbunden werden kann. Parallel kann über die Mess- und Steuereinrichtung 13 eine Zündelektrode 15 mit einem Kondensator 16 verbunden werden, der mit einer gesonderten Stromversorgung verbunden oder am Potential einer Niederspannungsquelle, im Beispiel an der Stromquelle 7, liegen kann. Die Zündelektrode 15 ist im Raum zwischen der Hochspannungselektrode 14 und dem Target 3 und in dessen räumlicher Nähe angeordnet.

Verfahrensgemäß wird zum erstmaligen Start der Vakuumbogenentladung über die Mess- und Steuereinrichtung 13 und den Schalter 17 die Hochspannungselektrode 14 mit der Hochspannungsquelle 20 verbunden. An der Hochspannungselektrode 14 liegt somit eine Spannung von beispielhaft 3 kV an. Diese Energie reicht jedoch nicht zur Zündung einer Vakuumbogenentladung aus. Erst wenn über den Schalter 18 der Kondensator 16 zur Zündelektrode 15 hin entladen wird, kommt es zu einer Zündleistung von etwa 70 kW und einem dichten Plasma, welches die Ausbildung eines Vakuumbogens am Target 3 bewirkt

### Bezugszeichen

- 1: Vakuumkammer
- 2: Vakuumbogenverdampfer
- 3: Target
- 4: Vakuumanschluss
- 5: Gaseinlass
- 6: Masse
- 7: Stromquelle
- 13: Mess- und Steuereinrichtung
- 14: Hochspannungselektrode
- 15: Zündelektrode
- 16: Kondensator
- 17: Schalter
- 18: Schalter
- 19: Gaseinlass, partiell im Bereich der Zündelektroden
- 20: Hochspannungsquelle

## Patentansprüche

1. Vorrichtung zum Zünden einer Vakuumbogenentladung mit einem in einer Vakuumkammer (1) angeordneten und ein Target (3) aufweisenden Vakuumbogenverdampfer, wobei zwischen dem als Kathode geschalteten Target (3) und einer anodischen Hochspannungselektrode (14) eines Vakuumbogenverdampfers (2) mittels einer Hilfsplasmaeinrichtung eine Vakuumbogenentladung ausbildbar ist, wobei die Hilfsplasmaeinrichtung eine Zündelektrode (15) aufweist, wobei
- die Hilfsplasmaeinrichtung eine Hochspannungsquelle (20) aufweist,
- die mit der anodischen Hochspannungselektrode (14) verbunden werden kann,
- dass die Zündelektrode (15) im Raum zwischen dem Target (3) und der Hochspannungselektrode (14) angeordnet ist,
- dass ein Kondensator (16) vorhanden ist, der zur Zündelektrode (15) hin entladen werden kann, und
- dass die Zündelektrode (15) sowie die Hochspannungselektrode (14) mit einer Mess- und Steuereinrichtung (13) zur Erfassung und Regelung der elektrischen Parameter kontaktiert sind.

2. Vorrichtung zum Zünden einer Vakuumbogenentladung nach Anspruch 1, wobei die Hochspannungsquelle (20) geeignet ist, über die Mess- und Steuereinrichtung (13) eine Hochspannung mit einer AC- oder DC-Leistung größer 10 W an der Hochspannungselektrode (14) bereitzustellen.

3. Vorrichtung zum Zünden einer Vakuumbogenentladung nach Anspruch 2, wobei der Kondensator (16) geeignet ist, über die Mess- und Steuereinrichtung (13) an die Zündelektrode (15) eine Zündleistung abzugeben, die in Überlagerung mit dem AC- oder DC-Plasma an der Hochspannungselektrode (14) einen Zündimpuls mit einer Zündleistung zwischen 30 und 100 kW, vorzugsweise 70 kW, erzeugt.

4. Verfahren zur Anwendung der Vorrichtung zum Zünden einer Vakuumbogenentladung nach Anspruch 1, bei dem nach Einstellung der erforderlichen Prozessparameter in der Vakuumkammer (1) und der elektrischen Verfahrensparameter am Vakuumbogenverdampfer (2) mittels der Hilfplasmaeinrichtung die Hochspannungsquelle (20) zwischen der Hochspannungselektrode (14) und dem Target (3) ein Plasma erzeugt, welches unmittelbar nicht geeignet ist, eine Vakuumbogenentladung am Vakuumbogenverdampfer (2) auszulösen, und dass nachfolgend mittels der Mess- und Schalteinrichtung (13) vom Kondensator (16) zur Zündelektrode (15) hin eine Kondensatorentladung ausgelöst wird, wodurch eine Zündleistung zwischen 30 und 100 kW, vorzugsweise 70 kW, ausgebildet wird, wobei diese geeignet ist, eine Vakuumbogenentladung am Vakuumbogenverdampfer (2) auszulösen.

5. Verfahren nach Anspruch 4, wobei nach Zündung der Vakuumbogenentladung am Vakuumbogenverdampfer (2) der Kondensator (16) über die Mess- und Steuereinrichtung (13) von der Zündelektrode (15) elektrisch getrennt und wieder aufgeladen wird.

## Claims

1. Apparatus for igniting a vacuum arc discharge by means of a vacuum arc evaporator which is arranged in a vacuum chamber (1) and comprises a target (3), wherein a vacuum arc discharge can be formed between the target (3), which is connected as a cathode, and an anodic high-voltage electrode (14) of a vacuum arc evaporator (2) by means of an auxiliary plasma device, wherein the auxiliary plasma device comprises an ignition electrode (15), wherein
- the auxiliary plasma device comprises a high-voltage source (20),
- which high-voltage source can be connected to the anodic high-voltage electrode (14),
- the ignition electrode (15) is arranged in the space between the target (3) and the high-voltage electrode (14),
- a capacitor (16) is provided, which can be discharged towards the ignition electrode (15), and
- the ignition electrode (15) and the high-voltage electrode (14) are contacted by a measurement and control device (13) for detecting and controlling the electrical parameters.

2. Apparatus for igniting a vacuum arc discharge according to claim 1, wherein the high-voltage source (20) is suitable for providing a high voltage having an AC power or DC power greater than 10 W at the high-voltage electrode (14) by means of the measurement and control device (13).

3. Apparatus for igniting a vacuum arc discharge according to claim 2, wherein the capacitor (16) is suitable for delivering an ignition power to the ignition electrode (15) by means of the measurement and control device (13), which ignition power, in superimposition with the AC plasma or DC plasma, generates an ignition pulse at the high-voltage electrode (14) with an ignition power between 30 and 100 kW, preferably 70 kW.

4. Method for using the apparatus to ignite a vacuum arc discharge according to claim 1, in which method, after setting the required process parameters in the vacuum chamber (1) and the electrical method parameters at the vacuum arc evaporator (2), the high-voltage source (20) generates a plasma between the high-voltage electrode (14) and the target (3), by means of the auxiliary plasma device, which plasma is not immediately suitable for triggering a vacuum arc discharge at the vacuum arc evaporator (2), wherein subsequently a capacitor discharge from the capacitor (16) to the ignition electrode (15) is triggered by means of the measurement and switching device (13), as a result of which an ignition power between 30 and 100 kW, preferably 70 kW, is formed, wherein said ignition power is suitable for triggering a vacuum arc discharge at the vacuum arc evaporator (2).

5. Method according to claim 4, wherein, after ignition of the vacuum arc discharge at the vacuum arc evaporator (2), the capacitor (16), by means of the measurement and control device (13), is electrically separated from the ignition electrode (15) and recharged.

## Revendications

1. Dispositif destiné à amorcer une décharge en arc sous vide,
comprenant un évaporateur à arc sous vide disposé dans une chambre à vide (1) et comportant une cible (3), une décharge en arc sous vide pouvant être produite au moyen d'un moyen à plasma auxiliaire entre la cible (3) connectée en tant que cathode et une électrode anodique haute tension (14) d'un évaporateur à arc sous vide (2), le moyen à plasma auxiliaire comportant une électrode d'amorçage (15),
- le moyen à plasma auxiliaire comportant une source haute tension (20),
- laquelle peut être reliée à l'électrode anodique haute tension (14),
- l'électrode d'amorçage (15) étant disposée dans l'espace entre la cible (3) et l'électrode haute tension (14),
- un condensateur (16) qui peut être déchargé vers l'électrode d'amorçage (15) étant présent, et
- l'électrode d'amorçage (15) ainsi que l'électrode haute tension (14) étant mises en contact avec un moyen de mesure et de commande (13) pour acquérir et régler les paramètres électriques.

2. Dispositif destiné à amorcer une décharge en arc sous vide selon la revendication 1, dans lequel
la source haute tension (20) est appropriée pour fournir à l'électrode haute tension (14), par l'intermédiaire du moyen de mesure et de commande (13), une haute tension d'une puissance alternative ou continue supérieure à 10 W.

3. Dispositif destiné à amorcer une décharge en arc sous vide selon la revendication 2, dans lequel
le condensateur (16) est approprié pour délivrer à l'électrode d'amorçage (15), par l'intermédiaire du moyen de mesure et de commande (13), une puissance d'amorçage qui, en superposition avec le plasma alternatif ou continu, génère au niveau de l'électrode haute tension (14) une impulsion d'amorçage d'une puissance d'amorçage comprise entre 30 et 100 kW, de préférence 70 kW.

4. Procédé d'utilisation du dispositif d'amorçage d'une décharge en arc sous vide selon la revendication 1, dans lequel, après le réglage des paramètres de processus requis dans la chambre à vide (1) et des paramètres électriques de procédé au niveau de l'évaporateur à arc sous vide (2), la source haute tension (20) génère un plasma entre l'électrode haute tension (14) et la cible (3) au moyen du moyen à plasma auxiliaire, lequel plasma n'est pas directement approprié pour déclencher une décharge en arc sous vide au niveau de l'évaporateur à arc sous vide (2), et dans lequel une décharge de condensateur est ensuite déclenchée au moyen du moyen de mesure et de commande (13) du condensateur (16) vers l'électrode d'amorçage (15), moyennant quoi une puissance d'amorçage comprise entre 30 et 100 kW, de préférence de 70 kW, est produite, laquelle est appropriée pour déclencher une décharge en arc sous vide au niveau de l'évaporateur à arc sous vide (2).

5. Procédé selon la revendication 4, dans lequel,
après l'amorçage de la décharge en arc sous vide au niveau de l'évaporateur à arc sous vide (2), le condensateur (16) est séparé électriquement de l'électrode d'amorçage (15) et rechargé par l'intermédiaire du moyen de mesure et de commande (13).
